# EUROPEAN PATENT APPLICATION

(11) **EP 1 119 229 A1**
(43) Date of publication of application: **25.07.2001**
(21) Application number: 00115213.1
(22) Date of filing: 13.07.2000
(51) Int. Cl.: H05K 7/14, H01R 13/645

(54) **Coded electrical device**

(30) Priority: 24.01.2000 US 490673; 07.01.2000 EP 00100306
(71) Applicant: Weidmüller Interface GmbH & Co., 32760 Detmold (DE)
(72) Inventor: Zebermann, Christoph, 37688 Beverungen (DE); Dux, Dietmar, 32758 Detmold (DE); Wilmes, Manfred, 32760 Detmold (DE); Schnatwinkel, Michael, 32051 Herford (DE); Steinmeier, Rudolf, 32760 Detmold (DE); Hanning, Walter, 32758 Detmold (DE)
(74) Representative: Specht, Peter, Dipl.-Phys.

(57) **Abstract**

The invention provides a coded connector arrangement for permitting the displacement of a pair of authorized components (2, 14) in a given direction toward each other from a diconnected position to a fully connected position, comprising a pair of cooperating connector elements (64, 48); and means (76, 82) for mounting said connector elements in opposed relation on the adjacent surfaces of said pair of components, respectively, characterized in that oblique portions (100) of laterally obliqued edges (82) or the laterally obliqued edges (82) of a base portion (84) of one of the connector/coding elements (64), which - when this coding element (64) is inserted into recess (62) of a base terminal unit (2) engage undercut (86) - extend about a part, preferably the half, of the width of base portion (84) so that it is possible after a lateral shift on the base terminal block (2) to pull this connector/coding element (64) upwardly from the base terminal block (2).

## Description

### BACKGROUND OF THE INVENTION

### FIELD OF THE INVENTION

This invention relates to a coding arrangement including a pair of matched coding elements that are respectively connected between a pair of components, such as a terminal block and a printed circuit board, so that only authorized components can be electrically connected with each other.

### Background of the Invention

Various coding arrangements are well known in the prior art. In the German patent No. DE 38 30 187, for example, there is disclosed a coding device for switchboard plug-in modules for the purpose of definite match up of plug-in modules and plug-in chambers with the help of coding projections on the module and coding devices corresponding therewith on the module support. The coding projections are attached on the underside of a module bottom, standing perpendicularly in a row at a right angle to the direction of insertion. On the bottom sheet metal piece of the module block, there is provided a coding plate with grooves located in the direction of insertion whose interval corresponds to the interval between the coding projections. The coding projections protrude into the grooves. Coding systems such as these entail the disadvantage that coding in practice is often dispensed with due to the effort connected with assembly. But this can lead to problems or damage, for instance, because various potentials, (for example, 24 V and 230 V) can be combined.

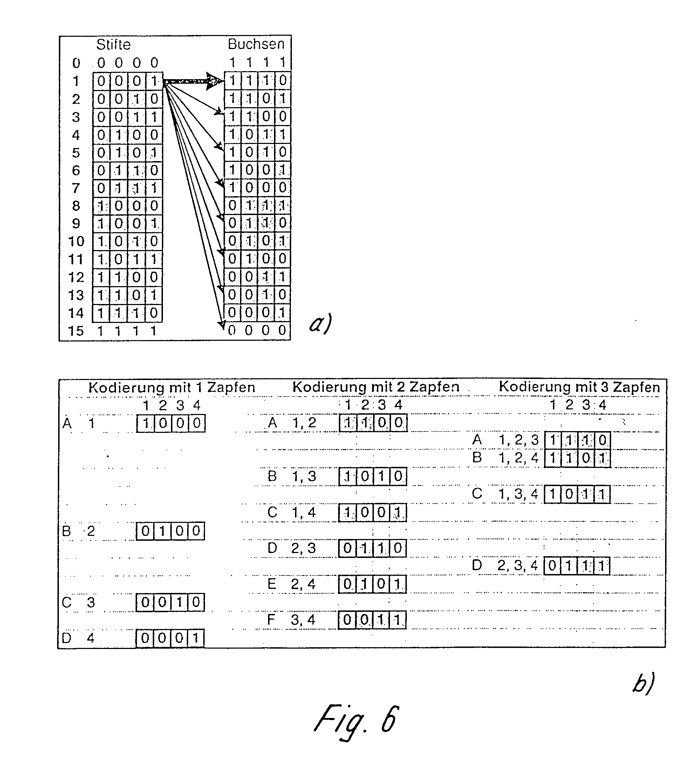

According to the prior art coding arrangement of Fig. 6, the problem arises that codings with few projections can be stuck into coding receptacles with free socket holes. For instance, pin "1" in Fig. 6 can be stuck not only in socket "1" but also into sockets "3, 5, 7, 9, 11, 13, 15." This does not reliably rule out the possibility of making a mistake in sticking the pin in. The problem therefore is this, as Fig. 6 furthermore shows by way of example: If one has a total of four peg locations with one and three projections, then out of the theoretical 16, one can make only four coding variants that really differ from each other. If there are five peg positions, then there are ten genuine differentiation possibilities.

Starting with this state of the art, the present invention is intended to provide a simple coding system that is distinguished by high coding assurance and a large number of coding variants that can also be implemented in a narrow space. Another part of this problem involves ensuring the fact that the coding device can be assembled in an uncomplicated and quick manner.

The present invention was developed to avoid the above and other drawbacks of the known coding systems.

### Summary of the Invention

Accordingly, a primary object of the present invention is to provide a coding arrangement in which a pair of coding elements are connected between a pair of authorized components, such as a terminal block and a printed circuit board, whereby only the authorized pair of components can be displaced together toward a fully connected position.

According to a more specific object of the invention, the pair of coding elements each include a pair of anguarly arranged coding surfaces each contained in a plane normal to the direction of connection of the components, the corresponding coding surfaces of the coding elements being parallel with each other. One of the coding elements includes a male projection or peg that extends in the direction of the other coding member and that carries one pair of angularly arranged coding surfaces. The corresponding pair of angularly arranged coding surfaces is formed either on projections on the other coding element, or on the walls of a non-circular female socket. The projections and/or sockets that can be assembled in each case essentially have a polygonal cross-section and form a part of a base surface -- in particular, a regular polygon or a non-circular surface -- on which they are aligned according to a coding system where the projections of the first and the projections and/or sockets of the second coding element in each case essentially rest with one of their outer sides against the circumference of the base surface and where, in case of different coding element variants, they rotate along the circumference of the base surface or are twisted with respect to each other. This coding system ensures a large number of coding variants so that any confusion can be eliminated. This is true, in particular, when two or more of these base surfaces or polygons are lined up directly along each other; one then gets a particularly large number of different reliably plugged-in coding variants in conjunction with the definite position match up (ensuring against twisting) of the components that are provided with the coding device; this can be done in a very tight space.

According to another object of the invention, the corresponding projections and/or sockets essentially have rectangular cross-section that amounts to about half the surface of the base surface that is made as a square area. It is furthermore practical when one of the longitudinal sides of the rectangular projections or sockets rests against one of the outer sides of the square area and/or when the surfaces of the different projection/projection or projection/socket combinations partly overlap each other. This coding system facilitates on a single square area -- with an edge that, for instance, amounts to only a few millimeters -- the implementation of four different coding variants. The number of coding variants can be multiplied by lining up these square areas to receive the rectangular projections and sockets. In that way, with two areas lined up to each other in a narrow space, one can already implement 16 coding variants, and with three areas lined up next to each other in a row, one can make even 64 coding variants on a particularly narrow surface.

As another preferred embodiment that implements even more coding variants on one base surface, the base surface is made as a hexagon; the pegs are made as half-hexagonal surface or as a third of the hexagonal surface (135" element) and the pins for various coding variants are offset with respect to each other along the outer circumference in 60° steps. That idea can be carried forward with any number of hexagons; as the number of comers increases, one can, of course, theoretically increase the wide variety of coding variants on one base surface. But some time along the way, one encounters the problem of peg positions that will differ only very little from each other if the base surface is presumed to remain equally large.

The invention, moreover, solves another problem according to a particularly preferred embodiment. In electrical appliances, where in all units a uniform first component must be combined with a different second component, in other words, in electrical appliances that are built up on the basis of terminal blocks, which must be provided with different electronic housings, it so happens that storage is made more difficult by the coding devices, because for each electronic housing with the first coding element section, one must keep in stock a fitting terminal body with the corresponding second coding element section. To solve this problem, the two coding element sections can together be placed upon the first component and are so designed that when the two components are assembled, the second coding element section will so come to rest against the second component that upon separation of the two components from each other, the second coding element section will remain on the second component so that it forms a counterpart for the first coding element section that remains on the first component when the two components are separated from each other.

The present invention is particularly suitable for this embodiment, since the second coding element section that is attached to the base terminal unit is so made that when the housing is the set upon a base component, for example, the base terminal block, it will be retained in a recess in which it remains after removal of the housing from the base terminal block so that it forms the counterpart for the first coding element section that remains on the electronic housing upon the withdrawal of the electronic housing. In contrast to the prior art, this offers the following advantage: one of the two components, in particular, the base terminal units, during their production need not be provided with any coding device or with any of the coding element sections so that the storage of these components is considerably simplified. The electronics units of varying types -- for example, electronics units to implement communication between a first field bus and actors, initiators, etc. -- on the other hand, are in each case provided with a differing, bipartite coding element; the second coding element section is "put down" upon the base terminal unit only when the electronic unit is first put on the base terminal unit. In case the electronic unit is exchanged later, the second coding element section remains on the base terminal unit and protects the electrical appliance that is made up of the base terminal units against inadvertent imposition of a "false" electronic unit with a coding that does not fit. This idea can be combined particularly advantageously with the invention-based coding system that can be made in a narrow space.

With regard to the second part of the problem that can also be contemplated independently, that is, to ensure that the coding device can be assembled in an uncomplicated and fast fashion, the invention solves the problem in the following manner: The two coding element sections of each coding element are connected integrally via constrictions or rip-off edges with a flexible base unit, in particular, a handle upon which the two coding element sections can be assembled to form one coding element. The handle is preferably made as a plastic strap that can be bent by hand. The plastic strap is so dimensioned that the two coding element sections of the two coding elements that belong together can in each case be put together at the strap to form the coding element; therefore, one can reliably rule out any confusion during assembly. Besides, the handling is simple and one can prevent a situation where one must try to match up two mutually fitting elements during assembly. This high degree of safe assembly is further enhanced by a legend that is affixed upon the handle.

Another object of the invention is to provide a method for easily making the various coding devices of the coding system. For this purpose, one preferably provides a single mold with a number of recesses that corresponds to the number of coding variants to make the different variants of coding element sections so that all variants can be made in just one production cycle. The manufacturing process is further simplified in the following manner: For the various coding elements, different numbers of recesses are provided in the mold so as to corresponds to their frequency distribution. In a particularly preferred manner, the differing coding variants are assembled to form groups in the mold in keeping with the frequency arising from the particular purpose (for example, three groups: particularly frequently needed coding variants, normally frequent variants, rare variants). In this way, when one uses only one single tool, one can avoid the unnecessary production of variants that occur very infrequently.

### Brief Description of the Drawings

Other objects and advantages of the invention will become apparent from a study of the following specification, when viewed in connection with the accompanying drawings, in which:
Fig. 1 is an exploded front perspective view of a terminal block including the coding connector means of the present invention;
Fig. 2a is a detailed exploded view of the connection between the printed circuit board and the terminal block, and Fig. 2b is an exploded detailed view of the pair of coded connector elements;
Figs 3a-3c are diagrammatic illustrations of cross sections of the male projections that are portions of a square, a hexagon and an octagon, respectively, and Fig. 3d is a schematic view of a coding connector having a plurality of pairs of corresponding code patterns;
Figs. 4a and 4b illustrate two further connectors having pairs of corresponding code patterns;
Figs. 5a-5e' are diagrammatic views illustrating the method steps of forming a pair of coding elements in accordance with the present invention;
Figs. 6a and 6b illustrate two further coding arrangements for the connectors; and
Fig. 7a is a front view of a plurality of different pairs of coded connectors, and Figs. 7b and 7c are right side and front views illustrating the method of manufacture of a given pair of coded elements.

### Detailed Description

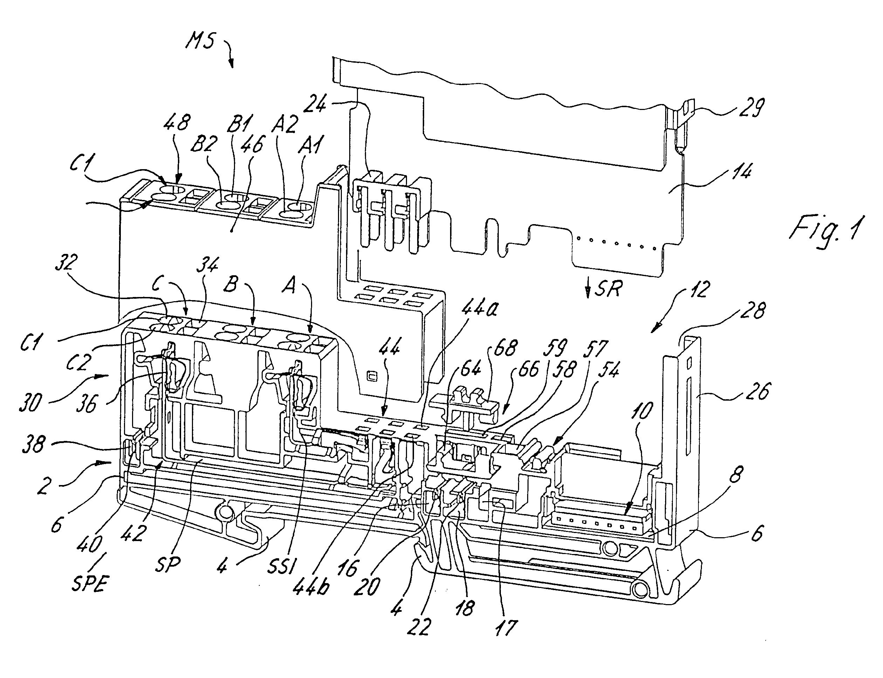

Fig. 1 shows a module disc MS for an appliance used in automation technique that is not otherwise illustrated here. The appliance comprises a gateway (not illustrated here) along which one may, among other things, line up the module disc MS. Module disc MS can be assembled with other modules discs MS to form a connection block of variable length.

Module disc MS, according to Fig. 1, has a disc-shaped base terminal block 2 to lock the individual model upon a carrying rail R (not shown here). Base terminal block 2 for this purpose is provided with plastic notch feet 4 with whose help one can assemble the notch connection to the carrying rail in the known fashion. Base terminal block 2 comprises a lower base portion 6, which extends into an area above carrying rail feet 4 and adjacent the block rail feet 4 on both sides laterally beyond the ca carrying rail. In base portion 6, there is provided in an outer area facing away from the carrying rail a bus conductor opening 8 that penetrates the base terminal block 2 and extends normal to its main extent plane for the purpose of receiving the internal bus conductor unit 10. That makes it possible to relay the bus conductor signals from individual module to individual module and into the electronic printed circuit board 14.

To receive the electronic printed circuit board 14, there is provided in base terminal block 2 a circumferential recess 12 in the area which extends approximately from the line that is perpendicular to the center of the carrying rail up to the internal bus conductor segment 10. Electronic circuit board 14 is provided with an electronic circuit (not shown here) for the processing/relaying of the signals that are supplied to electronic printed circuit board 14.

In the area located between the internal bus conductor unit 10 and the notch foot 4, the base portion 6 is provided with three additional, adjacent openings 16, 17, 18 that in each case penetrate the base terminal block 2 to the main disc plane of module MS and two of which openings, 16, 18, are provided with contact elements 20, 22 that are preferably designed as integral cross-bridges provided on one side with a plug pin on the other side with the appropriately fitting, integrally molded socket 20b, 22b as well as molded-on contact seats that extend orthogonally upwardly, which make it possible to relay the associated potentials -- preferably the plus or minus supply potential -- from module to module. Contact elements 20, 22 constitute potential guides as they cooperate. The other opening 17 -- just as the openings in the base terminal block, which are not described here -- merely serves to save material. Cross-bridges 20, 22 conduct these potentials to the printed circuit board and/or via a suitable separate plug 24 or a plug that is placed upon the electronic printed circuit board to the connections of the bus bars SM, SP in base terminal block 2 and via the former to the contact planes of module disc MS.

Recess 12 is bordered on the end of the individual module that faces away from the carrying rail by a connecting support wall 26 that extends normal to the base segment and that on its side f acing toward the support rail 4 is provided with a module groove 28 for the purpose of inserting the electronic printed circuit board 14 as well as an electronic housing 29.

Roughly on the end of base terminal block 2 that is opposite connecting plank 26, there is molded upon base segment 6 a connection portion 30 that protrudes orthogonally upwardly and that is provided with six individual connections (A1, A2) and double connections Bl, B2, Cl, C2 that are arranged in two rows of three each. Openings 34 with the quadratic cross-section next to connection openings 32 for connections A1, A2, B1, B2, etc., make it possible to introduce a screwdriver to open the spring contact elements 36 that are arranged in connecting portion 30. Outside the third connection plane C, there is provided in the base portion an additional opening 38 that lies normal to the module plane and that penetrates the base terminal block 2 in which opening lies an additional contact opening 40 via which the ground conductor SPE is relayed from individual model to individual model.

The conducting connection between resilient contacts 36 of connections A, B, C, etc., and electronic printed circuit board 14 is accomplished by means of bus bars SM (for the minus potential, which is not shown here), SP (for the plus potential), SSI (for the signal), which in each case, first of all, extend from the resilient contacts 36 in connection area 30 of base terminal block 2 orthogonally downwardly into base segment 6 and are then conducted in base segment 6 to the electronic printed circuit board 14. Bus bars SM, SP extend from contact springs 36 into lateral grooves /recesses 42 of base element 2 essentially in U-shaped fashion on both main outside surfaces of the base terminal block 2. Below recess 12 for the electronic printed circuit board, the bus bars are angled upward and run to the circumferential recess 12, which in this area is provided with six connection openings 44 arranged in two rows next to each other for the purpose of setting appliance plug 24 upon the electronic printed circuit board and/or the printed circuit board edge. The terminal areas of bus bars SSI, SM, SP are made as punched bending part sockets and, as such, form the connection sockets for appliance plug 24 to electronic printed circuit board 14 and/or to the printed circuit board edge.

A particularly space-saving arrangement of the bus bars can be achieved in the following manner: One of the potential-carrying bus bars SM is run on one outside and the other potential-carrying bus bar SP is run on the other outside of base terminal block 2. Through-contacting between the two double connections B1, B2, etc., that lie next to each other in a connection plane B or C takes place only in the area of connection springs 36.

A cover housing 46 made of synthetic plastic material is mounted over the connection portion 30; the housing has openings 48 that correspond to the connection openings 32 and the openings 34. Toward the area of recess 12 of the base terminal block 2, the cover is furthermore provided with a lateral groove 50, which in cooperation with groove 28 receives the electronic printed circuit board 14 and housing 29 that protects electronic circuit board 14, which housing can be set upon the base terminal block 2 in plug direction SR. Guide projections on the base terminal block engage corresponding openings in the adjacent terminal, thereby to provide a mechanical connection between the terminal blocks 2 that are lined up with each other.

In the region of the recess 12, the terminal block 2 or module MS includes the following areas or elements:

| | |
|---|---|
| Module bus opening | BUS/8 |
| Marking slot (for one or two togs) | 54 |
| Lateral notch hook with opening from above | |
| Functional ground contact | 58 |
| Voltage guiding contact opening | 59 |
| Plug sockets/connection openings | 44 |
| Adjacent the FE contact | |

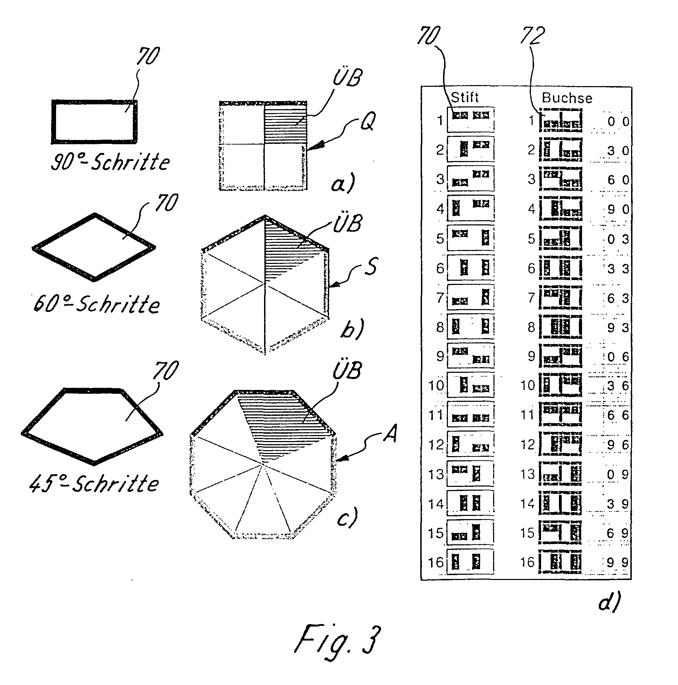

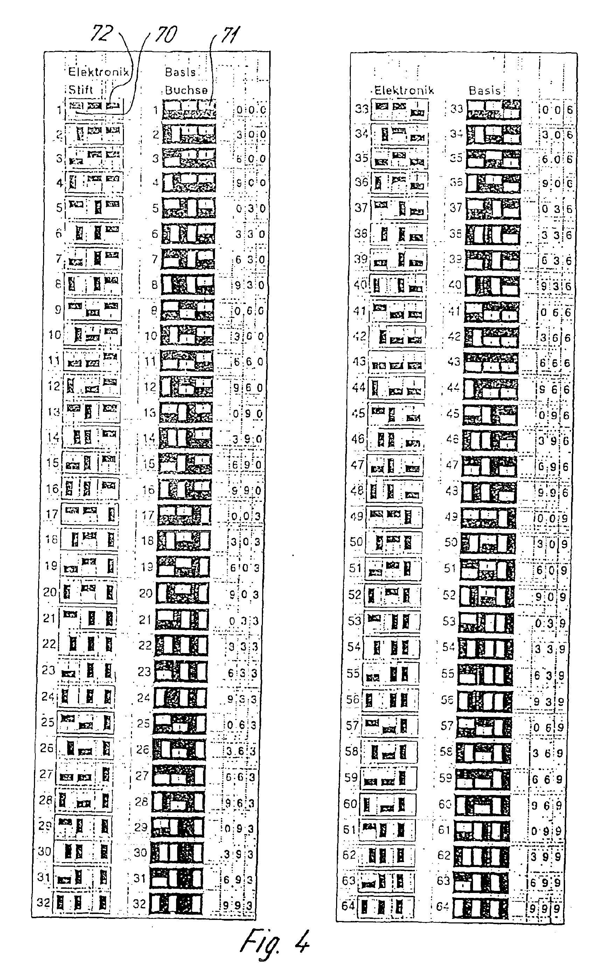

Adjacent the FE contact 58 and openings 44 to potential conductors PE+, PE-, there is provided in a space conserving manner a recess 62 that receives the lower coding element 64 of coding means 66 that also includes an upper coding element 68 that is connected with the printed circuit board 14. The coding is achieved by cooperating projections (or pegs) 70 and 72 on the upper and lower connection members 68 and 64, respectively. These projections carry correspondingly angularly arranged pairs of coding surfaces 68 and 80, respectively that extend normal to the direction of displacement SR of the printed circuit board relative to the terminal block 2 mounted on support rail R. Alternatively, as shown in Figs. 3a-3d and 4a and 4b, sockets or female openings 71 may be provided in one of the connection members for receiving the male projection 70 on the other connection member. Thus, an authorized printed circuit board may be connected only with the authorized terminal board when corresponding coding surfaces 78 and 80 on the projections or sockets are parallel.

As electronic housing 29 is initially mounted upon base terminal block 2, the upper coding element section 68 that is engaged with notch noses 74 in recesses 76 of the electronic housing 29 is guided into opening 62 together with the assembled lower coding element 64. The upper coding element 68 engages the lower coding element section 64 by means of notch noses and notch recesses 78, 80 upon projections 70, 72, respectively. The oblique edges 82 of base portion 84 of the lower coding element section 65 grasp behind undercuts 86 of recess 62 in such a manner that when electronic housing 29 is removed from base terminal block 2, notch noses 89 and notch recesses 80 on the projections are of course separated from each other, but not the lower coding element section 64 out of the base terminal block 2. In that way, the user can set any desired electronic unit on the base terminal block 2 and thus implement the particular necessary coding function. Consequently, it is not necessary to keep a large inventory of the most varied complete module assemblies.

A rectangular pin 88, attached to coding element 68 for the purpose of engaging in an opening 90 of the second coding element, ensures protection against twisting of the two coding elements toward each other. If, instead of a solution with adjacent projections 70, 72 on the first and second coding element sections, one makes the kind with such projections 70, 72 and complementary sockets 71, then the mutual engagement of pin and socket already provides this security against twisting (Figs. 3, 4).

According to the embodiments of Fig. 3a and 3d, projections 70 are made as half-square surfaces. According to the additional embodiments of Figs. 3b and 3c, projections 70 are arranged in the form of section pieces along the outer circumference of a hexagonal base surface S (Fig. 3b) or an octagonal base surface A (Fig. 3c), respectively, which in different coding variants are twisted along the circumference by 60° (hexagon) or 45° (octagon) toward each other ("rotation"). In the case of different, for example, also adjacent variants, the projections overlap each other. In Fig. 3b, the projections form a lozenge (120° element); as an alternative, they can be made as half-hexagon (not shown). In Fig. 3c, projections 70 form a pentagon (135° element). Here again, they can be made as half-octagon (not shown). As the number of comers increases to a circle, one can increase the number of variants on a base surface in an uncomplicated fashion.

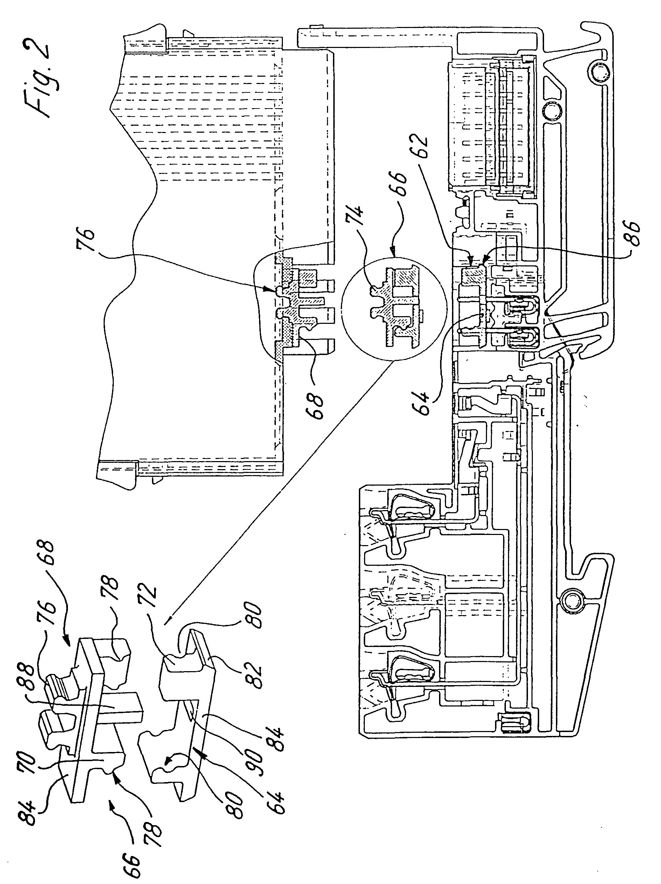

The type of arrangement of projections 70, 72 as mutually perpendicular projections or projections, in particular, those with rectangular cross-sections, permits a large number of coding variants in a narrow space. Reference is made in this connection to Figs. 3d and 4, wherein the adjacent projections 70 and sockets 71 essentially have a rectangular cross-sections, which generally takes up half the surface of a square area of the base portion on which the projections are aligned according to a coding system where the projections and sockets 70, 71, 72 of the first and of the second coding element in each case assume four different positions; here, essentially, one of the longitudinal sides of the rectangle rests against one of the outer sides of the square area (i.e., at 12 o'clock, 3 o'clock, 6 o'clock, 9 o'clock). In Fig. 2, base portions 84 of the first and of the second coding elements are provided with two mutually aligned square areas 0, and in Fig. 3, they are provided with three such square areas to receive the rectangular projections and sockets, as a result of which, one can reliably plug the illustrated 16 or 64 coding variants in a small space.

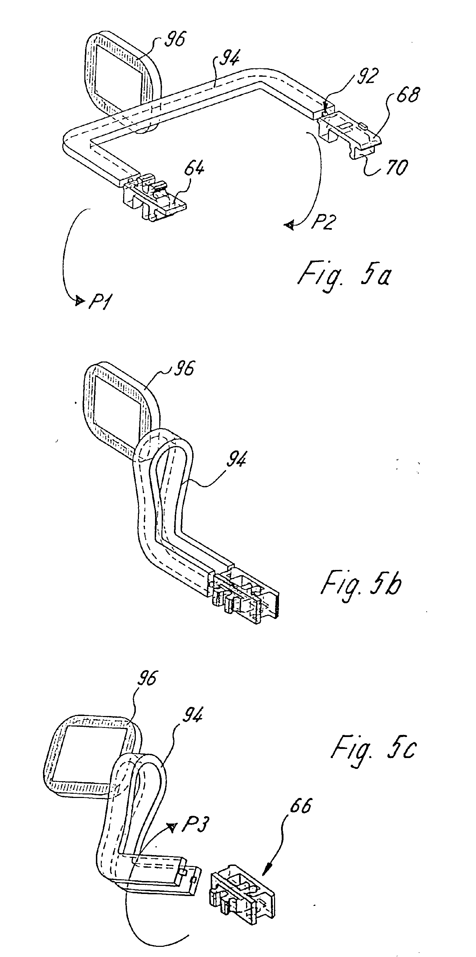

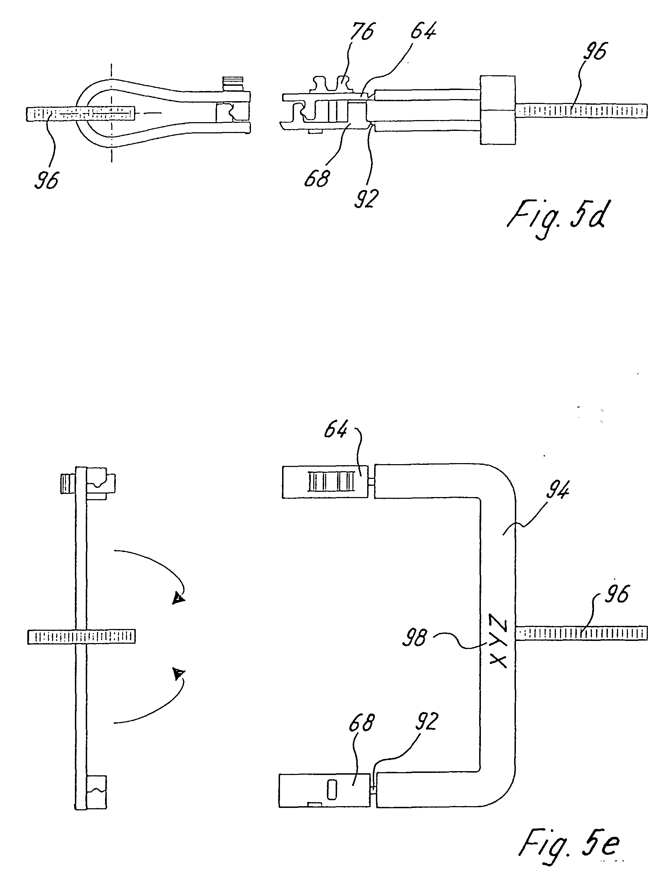

Figs. 5a-5e show an embodiment of the invention wherein the two coding elements 64, 68 of each coding means 66 are integrally molded via constrictions or tear edges 92 with the free ends of the legs portions of a flexible, U-shaped strap 94 with handle 96 that facilitates easy assembly of the coding assembly 66 and that minimizes the danger of confusion during assembly.

Figs. 5a and 5e' show the initial position as strap 94 engages next to coding element sections 64 and 68. As indicated by arrows P1 and P2, the flat, strip-like strap 94 can be so bent by hand that the two coding element sections 64 and 68 will engage together (Fig. 5b). Then the engaged coding element 66 is set directly upon a component to be coded (for instance, housing 29 in Fig. 1) and constriction 92 is torn up by a rotary movement in accordance with arrow P3 in Fig. 5c. In this manner, coding assembly 66 can be mounted as a unit upon electronic housing 29 from Fig. 1 with only one manual motion. In this way, one can reliably eliminate coding errors. Furthermore, the storage of coding elements and the assembly of coding elements on the electrical appliance are definitely simplified. Marking the strap portions 94 with indicia 98 simplifies the identification of the selected coding embodiment.

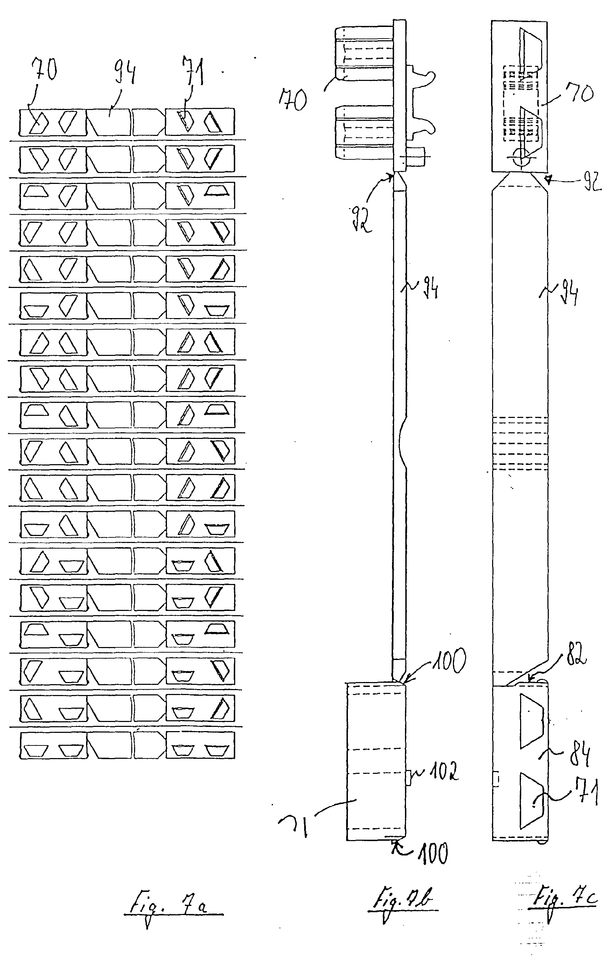

As shown in Fig. 7, projections 70 and sockets 71 are made as half-hexagonal base surfaces, which rotate along the circumference of the hexagon in 60° steps. This variant has proven to be particularly advantageous in practice because the design of pins 70 and sockets 71 as half-hexagonal surfaces ensures a particularly great degree of safety against the inadvertent assembly of coding variants that do not belong together. Besides, in a small space, one can implement a large number of coding variants that meet the requirements connected with most practical cases.

As shown in Fig. 7b, oblique portions 100 of the laterally obliqued edges 82 of base portion 84 of the second coding element section 64, which -- when the second coding element section 64 is inserted into recess 62 of base terminal unit 2 engage undercut 86-- extend only barely about half the width of base portion 84 and thus just far enough so that it is still possible after a lateral shift on base terminal block 2 to pull the second coding element section 64 orthogonally upwardly from the base terminal block 2 (something that is possible because base terminal block 2, altogether and particularly in this area, is somewhat narrower than the entire module disc MS in the manner of Fig. 1 with covers 29, 46 set on top). In this way, the second coding element section 64 can be separated only by a consciously intended operation. Thus the inadvertent withdrawal from base terminal block 2, perpendicularly upwardly, is rendered impossible. A projection 102, molded upon the bottom of base portion 84, is furthermore designed to engage a correspondingly shaped recess (not shown) on base terminal block 2 so that one can also prevent the inadvertent lateral shifting on base terminal block 2. On the other hand, a deliberate shift is possible, for example, with the aid of a screwdriver.

Therefore, the invention provides a coded connector arrangement for permitting the displacement of a pair of authorized components (2, 14) in a given direction toward each other from a diconnected position to a fully connected position, comprising a pair of cooperating connector elements (64, 48); and means (76, 82) for mounting said connector elements in opposed relation on the adjacent surfaces of said pair of components, respectively, characterized by oblique portions (100) of laterally obliqued edges (82) or the laterally obliqued edges (82) of a base portion (84) of one of the connector/coding elements (64), which - when this coding element (64) is inserted into recess (62) of a base terminal unit (2) engage undercut (86) - extend about a part, preferably the half, of the width of base portion (84) so that it is possible after a lateral shift on the base terminal block (2) to pull this connector/coding element (64) upwardly from the base terminal block (2).

## Claims

1. A coded connector arrangement for permitting the displacement of a paif of authorized components (2, 14) in a given direction toward each other from a diconnected position to a fully connected position, comprising:
(a) a pair of cooperating connector elements (64, 48); and
(b) means (76, 82) for mounting said connector elements in opposed relation
on the adjacent surfaces of said pair of components, respectively characterized by
(c) oblique portions (100) of laterally obliqued edges (82) or the laterally obliqued edges (82) of a base portion (84) of one of the connector/coding elements (64), which - when this coding element (64) is inserted into recess (62) of a base terminal unit (2) engage undercut (86) - extend about a part, preferably the half, of the width of base portion (84) so that it is possible after a lateral shift on the base terminal block (2) to pull this connector/coding element (64) upwardly from the base terminal block (2).

2. A coded connector arrangement as defined in claim 1, wherein the coding stop surface of each pair of connector elements are orthogonally arranged, and wherein the cross-section of said male projection (70) corresponds with one-half of a square (Q).

3. A coded connector arrangement as defined in one of the preceeding claims, wherein said male projection (70) has the cross-section of a portion of a hexagon (S), said coding stop surfaces on said male projection being arranged at an angle of preferably 60 degrees relative to each other.

4. A coded connector arrangement as defined in one of the preceeding claims, wherein said male projection (70) has the cross-section of a half of a hexagon (S).

5. A coded connector arrangement as defined in one of the preceeding claims, wherein said male projection (70) has the cross section of a portion of a hexagon (A), said coding stop surfaces an said male projection being arranged at an angle of 45 degrees relative to each other.

6. A coding connector arrangement as defined in one of the preceeding claims, wherein the coding stop surfaces on the other of said coded elements are carried by female socket opening operable to receive said male projection.

7. A coding connector arrangement as defined in one of the preceeding claims, wherein each of said coding elements includes a base plate portion (84) carrying a plurality of said coding stop surfaces.

8. A coding connector arrangement as defined in one of the preceeding claims, wherein said coding stop surfaces on said connector elements are cooperating nose projections (78) and grooves (80), respectively.

9. A coding connector arrangement as defined in one of the preceeding claims, wherein one of the components comprises a terminal block (2) mounted an a support rail ®, and further wherein the other of said components comprises a printed circuit board (14) having a housing (29) adapted for mounting in a recess (12) contained in said terminal block.

10. A coding connector arrangement as defined in one of the preceeding claims, wherein each of said coding elements comprises a base portion (84), the base portion of one of said coding elements having at one end a inclined locking surface (82) arranged for locking engagement with a corresponding locking recess (86) contained in a recess wall surface of the associated component (2).

11. A coding connector arrangement as defined in one of the preceeding claims, wherein said pairs of code stop surfaces are parallel with and normal to the plane of said cooperating components, respectively.

12. A coding connector arrangement as defined in one of the preceeding claims, wherein said mounting means are operable to removably connect said coding elements with the associated components, respectively.

13. A coding connector arrangement as defined in one of the preceeding claims, wherein one of said coding elements includes a projection (88) having a non-circular cross-sectional profile, and further wherein the other of said coding elements contains a bore (90) for receiving and projection, said bore having a cross-sectional profile that corresponds with the cross-sectional profile of said projection.

14. A coding connector as defined in one of the preceeding claims, comprising:
(a) a pair of initially spaced connector elements (64, 68);
(b) a trag (94) extending between said connector elements; and
(c) tear connection means (92) connecting the end of said strap with said connector elements, respectively.

15. A coding connector as defined in one of the preceeding claims, wherein the tear portions (92) define oblique edges (100) on the base of one of said coding elements, thereby to permit removal of said coding element in an upward direction relative to the associated component.

16. A coding connector as defined in one of the preceeding claims, wherein the base portion (84) of one of said coding elements includes an integral stop projection (102) that cooperates with an corresponding recess contained in the associated component, thereby to prevent lateral displacement of said coding element relative to said component.

17. A coding connector as defined in one of the preceeding claims, wherein the terminal block (2) is narrower than the entire module disc MS.
